# EUROPEAN PATENT APPLICATION

(11) **EP 2 184 958 A1**
(43) Date of publication of application: **12.05.2010**
(21) Application number: 08168855.8
(22) Date of filing: 11.11.2008
(51) Int. Cl.: H05K 1/03, C09K 21/12

(54) **Electronic assembly comprising a socket mounted on a pcb**

(71) Applicant: DSM IP Assets B.V., 6411 TE Heerlen (NL)
(72) Inventor: The designation of the inventor has not yet been filed
(74) Representative: van der Ploeg, Antonius Franciscus M.J.

(57) **Abstract**

The invention relates to an electronic assembly comprising a socket mounted on a PCB, wherein the PCB comprises a base plate made from a halogen free flame retardant thermoset resin composition and the socket comprises a base structure made of a halogen free flame retardant thermoplastic polymer composition comprising a polyamide polymer, a flame retardant system and optionally one or more other components wherein
- the polyamide polymer has a melting temperature of at least 255°C,
- the flame retardant system comprises a combination of a melamine condensation product and a phosphinic acid salt and/or a diphosphinic acid salt, and/or polymers of these
- the thermoplastic polymer composition comprises at most 1 wt.% relative to the total weight of the thermoplastic polymer composition of a metal borate, and
- the thermoplastic polymer composition has a melt flow length, measured by a spiral flow test in a spiral cavity with dimensions 280 x 15 x 1 mm at a temperature 20°C above the melt temperature of the polyamide polymer at 100 MPa effective injection pressure, of at least 150 mm.

The invention also relates to a halogen free flame retardant thermoplastic polymer composition, a socket made thereof and to a process for making the electronic assembly.

## Description

The invention relates to an electronic assembly comprising a socket mounted on a PCB, more particular to an electronic assembly wherein the PCB comprises a base plate made from a halogen free flame retardant thermoset resin composition and the socket comprises a base structure made of a halogen free flame retardant thermoplastic polymer composition. The invention also relates to a halogen free flame retardant thermoplastic polymer composition, a socket made thereof and to a process for making the electronic assembly.

In the past halogen containing flame retardant (HCFR) systems were widely used in the plastic materials employed in the electronic industry. In particular halogenated polymers optionally combined with flame retardant synergist or secondary flame retardants were used.

Halogen free technology has been evolving for several years, but has gained more emphasis during the last years, driven by the trend towards more environmentally friendly products. Whereas initially halogen free flame retardant (HFFR) polymer systems for use in various electronic components were developed, more recently also solutions were found for HFFR PCBs. However, by changing from halogen containing flame retardant systems to HFFR systems new problems have been encountered, either in the components as such or in the combination thereof. These problems become further more emphasized by the trend to further miniaturisation and environmentally more friendly processes, like lead free soldering involving higher soldering temperatures.

Materials widely employed in sockets for electronic applications include high temperature polyamides and LCPs. LCPs are intrinsically more flame retardant than polyamides, and also better flowing than polyamides, which latter require higher loads of flame retardants as well as reinforcing agent for mechanical properties. LCPs are the material of choice for connectors with long form factors, such a DDR, SODIMM, PCI, etc. Such connectors will be denoted in brief as "long sockets". However, it has been observed that replacement of HCFR PCBs by HFFR PCBs, in particular in rigid PCBs, in combination with the long sockets made of LCP raised problems of mechanical stress in the assembled parts after the lead free soldering, resulting in fracture of the soldering around the pins in the socket and malfunction of the electronic assembly.

Bonding reliability is also a problem observed in mounting of a quadratic semiconductor die, such as CPU socket, on a substrate, such as a PCB, as mentioned in US2007275504. In said patent this problem is linked to warpage and is solved by filling a small gap between the die and the substrate with a first cured resin filling a corner area of the die and a second cured resin filling a centre area of the die. A flexural modulus of the first cured resin is higher than a flexural modulus of the second cured resin. Such a solution is complicated and moreover not very convenient for long sockets.

In order to solve this problem, different approaches were investigated. It was observed that the HFFR PCBs had lower thermal expansion coefficients than the HCFR PCBs, which were already rather low. To reduce the thermal expansion of the LCP, filled LCPs were used. However, though the mechanical stress problem was reduced, the resulting LCP were too brittle and showed more blistering after the lead free soldering process. In other tests with different polyamides, which have intrinsically higher thermal expansion coefficients than LCPs any way, problems with blooming, corrosion and flow were encountered.

Therefore the aim of the invention is to provide an electronic assembly comprising a HFFR socket mounted on a HFFR PCB, while reducing the mechanical stress problems and other problems mentioned above.

This aim has been achieved with the electronic assembly according to the invention, wherein the PCB comprises a base plate made from a halogen free flame retardant thermoset resin composition and the socket comprises a base structure made of a halogen free flame retardant thermoplastic polymer composition comprising a polyamide polymer, a flame retardant system and optionally one or more other components wherein
- the polyamide polymer has a melting temperature of at least 255°C,
- the flame retardant system comprises a combination of a melamine condensation product and a phosphinic acid salt of the formula (I) and/or a diphosphinic acid salt of the formula (II), and/or polymers of these 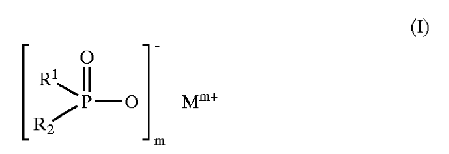 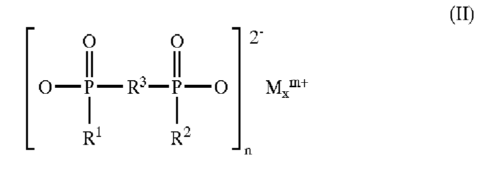 where
   R¹, R² are identical or different and are C₁-C₆- alkyl, linear or branched, and/or aryl;
   R³ is C1-C10-alkylene, linear or branched, C6-C10-arylene, alkylarylene or -arylalkylene;
   M is an Mg, Ca, Al, Sb, Sn, Ge, Ti, Zn, Fe, Zr, Ce, Bi, Sr, Mn, Li, Na, and/or K;
   m is 1 to 4;
   n is 1 to 4; and
   x is 1 to 4;
- the thermoplastic polymer composition comprises at most 1 wt.% relative to the total weight of the thermoplastic polymer composition of a metal borate, and
- the thermoplastic polymer composition has a melt flow length, measured by a spiral flow test in a spiral cavity with dimensions 280 x 15 x 1 mm at a temperature 20°C above the melt temperature of the polyamide polymer at 100 MPa effective injection pressure, of at least 150 mm.

The effect of the electronic assembly according to the invention is that the sockets could easily be produced from the polyamide composition, no blooming of flame retardant components was observed, corrosion was hardly visible if any and the problems due to mechanical stresses upon lead free soldering was significantly reduced or even completely gone.

This is in contrast with other approaches to solve this problem. The absence of blooming despite the high processing temperatures as well as the good flow despite the high loading contents of flame retardant and optionally reinforcing agents in the polyamide composition has been achieved both within the polyamide composition and allowed producing long sockets in a qualitative acceptable and economical manner. This results are also markedly in contrast with other patent publications claiming that zinc compounds, including zinc borates, improve the stability of phosphinate based flame retardant polymer compositions during processing and completely eliminate smoke generation during extrusion and injection moulding. The fact that with the sockets made of the polyamide composition according to the present invention the mechanical stress problem has been solved is in particular surprising in view of the high thermal expansion coefficients of the polyamide composition, in particular in comparison with those of the PCB material.

The PCB in the electronic assembly according to the invention may be made from any HFFR thermoset resin composition. Suitably, the thermoset resin composition comprises a cured phenolic, epoxy or polyester resin. The HFFR thermoset resin composition may also comprise other components, such as a filler and/or a fibrous reinforcing agent. Preferably the PCB is a rigid PCB comprising a fibrous reinforcing agent. An example of a PCB is a FR4 PCB, based on a glass fibre reinforced epoxy resin. The PCB may also comprise any halogen free flame retardant system. Suitable flame retardants include organic phosphor compounds and phosphate esters. Preferably the flame retardant comprises a phosphinate compound. These compounds perform well in epoxy resins, which are most widely used in PCBs. Examples of suitably phosphinate compounds include Exolit OP 935 and Exolit OP 1230 from the company Clariant.

The invention also relates to sockets that can be used in the electronic assembly according to the invention. Such a socket typically comprises a base structure made of a polymer composition and a number of metal pins. The invention in particular relates to long sockets, i.e. sockets with a large difference in length and width. Such sockets typically comprise a large number of pins per row. Such sockets are used for example as a DDR socket, a SODIMM socket, a PCI socket, or an FPC socket, etc.

In the present invention, a long socket is herein understood to comprise rows of at least 40 metal pins. The number of pins can suitably be as high as 80, 120, 150 or even higher e.g. the number of rows is not limited, but typically is relatively low compared to the number of pins in a row. The number of rows can suitably be from 1 to 10, for example 2, 3, 4, 5 or 6. Combinations of 2 rows with 80-150 pins in a row are quite common.

In the long socket according to the invention, the base structure has been made of a halogen free flame retardant thermoplastic polymer composition comprising a polyamide polymer, a flame retardant system and optionally one or more other components wherein the polymer composition is as described above.

These sockets are advantageously used in a mounting process for the production of an electronic assembly, wherein the socket is mounted on a PCB by a lead free soldering process with a peak temperature of at least 250°C, more particular wherein the PCB comprises a base plate made from a halogen free flame retardant thermoset resin composition.

The polyamide in the thermoplastic polymer composition used in respectively the electronic assembly and the socket according to the invention may be any polyamide having a melting temperature of at least 255 °C. With the term melting temperature is herein understood the temperature, measured according to ASTM D3418-97 by DSC with a heating rate of 10°C/min.

Suitably, the polyamide is a semi-crystalline aliphatic or semi-aromatic polyamide. Examples of a semi-crystalline aliphatic polyamide polyamide-4,6 and polyamide-6,6. Examples of semi-crystalline semi-aromatic polyamide are polyamide-6,6/6,T, polyamide-6T/61, and polyamide-66/MXDT. Use of semi-aromatic polyamides have the advantage that sufficient flame retardancy can be achieved with lower amounts of flame retardants and a better balance in mechanical and moulding properties.

Preferably, the polyamide has a melting temperature of at least 270°C, more preferably at least 280°C, and even better at least 290°C. Such a higher melting temperature results in better dimensional stability and retention of properties of the socket during the lead free soldering process.

The melamine condensation product may comprise any melamine condensation product. Examples include melem, melam and melon, and compounds of this type with a higher degree of condensation, or else mixtures of the same. Preferably the composition comprises melam. Melamine condensation products can be prepared for example via process as described in WO-A-96/16948.

Suitable phosphinates are described in WO97/39053.

In the phosphinates, M is preferably calcium, aluminium or zinc. R¹ and R², identical or different are preferably C1-C6 alkyl, linear or branched, and/or phenyl. R¹ and R², identical or different are particularly preferably methyl, ethyl, n-propyl, isopropyl, n-butyl, tert.-butyl, n-pentyl, and or phenyl. R³ is particularly preferably methylene, ethylene, n-propylene, isopropylene, n-butylene, tert.-butylene, n-pentylene, n-octylene, or n-dodecylene. Another preferred meaning of R³ is phenylene or naphthylene.

Particularly preferred are aluminium alkyl phosphinates, calcium alkyl phosphinates and zinc alkyl phosphinates. An example is Diethylaluminimphosphinate (depal) from Clariant.

In particular embodiments of the invention, the phosphinate compound is present in an amount in the range of 2-25 wt.%, preferably 5-15wt.%, and/or the melamine condensation product is present in an amount in the range of 5-25 wt.%, preferably 10 -22 wt.%, relative to the total weight of the thermoplastic polymer composition.

The phosphinate compound and the melamine condensation product are preferably present in a total amount in the range of 10-40, more preferably 20-35 wt.%, relative to the total weight of the thermoplastic polymer composition. The higher amounts result in better flame retardancy, while limiting the maximum amount allows for a better flow and better performance in the lead free soldering process. Higher amounts are favourably be used in combination with glass fibre reinforcement.

In a preferred embodiment, the melamine condensation product and the phosphinate compound are present in a weight ratio in the range between 20 and 0.05, preferably between 20 and 1, more preferably between 5 and 1.5, and even more preferably 4 - 2.

The thermoplastic polymer composition may further comprise one or more further additives. Suitable additives include fillers, reinforcing agents, stabilizers, processing aids, coloring agents, flame retardants. Preferably, the thermoplastic polymer composition comprises a filler and / or a fibrous reinforcing agent.

The filler and fibrous reinforcing agent can be present in an amount varying over a wide range. The filler and fibrous reinforcing agent may be present in a total amount as high as 50 wt.%, relative to the total weight of the composition, or even higher. Preferably, the total amount is at most 40 wt.% and suitably in the range of 5-35 wt.%.

Essential is that the thermoplastic polymer composition comprises at most 1 wt.% of a metal borate, wherein the wt.% is relative to the total weight of the thermoplastic polymer composition. Preferably the amount of metal borate is at most 0.5 wt.%, more preferably at most 0.2 wt.%. In particular when the metal borate is zinc borate such a low amount is preferred, and most preferably the composition does not comprise zinc borate at all.

The thermoplastic polymer composition used in the present invention has a spiral flow length of at least 150 mm. This flow length is determined on a spiral cavity with dimensions 280 x 15 x 1 mm at a temperature 20°C above the melt temperature of the polyamide polymer at 100 MPa effective injection pressure. Preferably, the spiral flow length is at least 160 mm and even better at least 170 mm. This allows for even better performance of the sockets in the lead free soldering process.

In a preferred embodiment, the thermoplastic polymer composition in the socket according to the invention has a flame retardancy rating, measured according UL standards, of at least V-2 at 1.6 mm. More preferably, the composition has V-2 rating at 0.8 mm. Also more preferably and, the UL rating is V-0 at 1.6 mm, or even better at 0.8.

To achieve the required flow behavior the polyamide polymer may comprise a blend of a two polyamides, one having a higher weight average molecular weight (Mw) than the other. Suitably, a polyamide polymer with a regular Mw is mixed with a polyamide polymer of low Mw. Such a polyamide polymer is also designated as a polyamide oligomer. Alternatively, the polyamide might be reduced in molecular weight. By varying the Mw of the polyamide and combining the polyamide with the flame retardant system with fillers and/or reinforcing agent, the skilled person can optimize the properties of the thermoplastic polymer composition through routine experiments.

In a particular embodiment the composition is a glass fiber reinforced polymer composition consisting of
(a) 75-30 wt.% polyamide polymer,
(b) 20-40 wt.% of a combined amount of the phosphinate compound and the melamine condensation product,
(c) 5-40 wt.% of glass fibers,
(d) 0-10 wt.% other components
wherein
- the wt.% of (a-d) is relative to the relative to the total weight of the composition and the sum of (a-d) is 100 %
- the thermoplastic polymer composition comprises at most 0.5 wt.% relative to the total weight of the thermoplastic polymer composition of a metal borate, and
- the thermoplastic polymer composition has a melt flow length, measured by a spiral flow test in a spiral cavity with dimensions 280 x 15 x 1 mm at a temperature 20°C above the melt temperature of the polyamide polymer at 100 MPa effective injection pressure, of at least 150 mm.

The flame retardancy rating of the thermoplastic polymer composition, measured according UL standards preferably is at least V-2 at 1.6 mm or better. The melamine condensation product preferably comprises melam, and the phosphinate compound preferably is an aluminium alkyl phosphinate, a calcium alkyl phosphinate or a zinc alkyl phosphinate, or any combination thereof.

The thermoplastic polymer compositions used in the present invention can be used by standard compounding techniques, and also processed with standard molding techniques, such as injection molding.

The socket according to the invention suitably is a DDR socket, a PCI socket, a FPC socket, or a SODIMM socket.

The invention also relates to a process for producing an electronic assembly comprising a socket mounted on a PCB as according to the invention described herein above. In this process, the socket is mounted on the PCB by a lead free soldering process with a peak temperature of at least 250°C.

The invention is further illustrated with the following examples and Comparative Experiments.

### Materials

M1: Unfilled LCP
M2: Filled LCP
M3: HFFR PA comprising a polyamide with a melting temperature of 290°C, 30 wt.% glass fibres, 20 wt.% melam, 7.5 wt.% depal, 2.5 wt.% zinc borate; V-0 at 1.6 mm and 0.8 mm.
M4: HFFR PA comprising 30 wt.% glass fibres, 20 wt.% melam, 10 wt.% depal; V-1 at 1.6 mm and 0.8 mm, spiral flow length 127 mm.
M4: HFFR PA comprising 3.5 wt.% polyamide oligomer, 30 wt.% glass fibres, 20 wt.% melam, 10 wt.% depal, V-1 at 1.6 mm and 0.8 mm, spiral flow length 166 mm.

### Injection moulding

The materials where used in injection moulding for the production of standard sockets with different dimensions, varying in the number of pins, with 120 respectively 150 pins in a row.

### Lead free soldering on a HFFR PCB

The sockets were used for the production of an electronic assembly by lead free soldering of the sockets on a HFFR FR4 PCB using a standard lead free soldering process with a peak temperature of 250°C.

### Results

M1 gave no problems in injection moulding, but a lot of rejects in the electronic assembly.
M2 was critical in injection moulding and lots of problems in the lead free soldering. The material was too brittle and the sockets already broke when positioned in the lead free soldering process.
M3 gave problems in injection moulding with mould deposit and corrosion of the screw of the injection moulding machine.
M4 gave problems in injection moulding and a lot of rejects in the electronic assembly. M5 worked smoothly in injection moulding and gave hardly any rejects in the electronic assembly. The lead free soldering was problem free.

## Claims

1. Electronic assembly comprising a socket mounted on a PCB, wherein the PCB comprises a base plate made from a halogen free flame retardant thermoset resin composition and the socket comprises a base structure made of a halogen free flame retardant thermoplastic polymer composition comprising a polyamide polymer, a flame retardant system and optionally one or more other components wherein
- the polyamide polymer has a melting temperature of at least 255°C,
- the flame retardant system comprises a combination of a melamine condensation product and a phosphinic acid salt of the formula (I) and/or a diphosphinic acid salt of the formula (II), and/or polymers of these 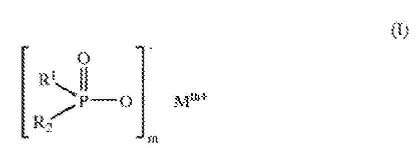 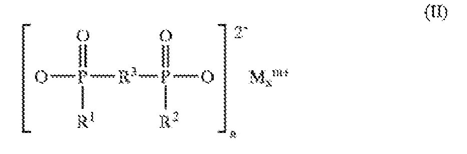 where
R¹, R² are identical or different and are C₁-C₆- alkyl, linear or branched, and/or aryl;
R³ is C1-C10-alkylene, linear or branched, C6-C10-arylene, alkylarylene or -arylalkylene;
M is an Mg, Ca, Al, Sb, Sn, Ge, Ti, Zn, Fe, Zr, Ce, Bi, Sr, Mn, Li, Na, and/or K;
m is 1 to 4;
n is 1 to 4; and
x is 1 to 4;
- the thermoplastic polymer composition comprises at most 1 wt.% relative to the total weight of the thermoplastic polymer composition of a metal borate, and
- the thermoplastic polymer composition has a melt flow length, measured by a spiral flow test in a spiral cavity with dimensions 280 x 15 x 1 mm at a temperature 20°C above the melt temperature of the polyamide polymer at 100 MPa effective injection pressure, of at least 150 mm.

2. Electronic assembly according to claim 1, wherein the HFFR thermoset resin composition comprises a cured phenolic, epoxy or polyester resin.

3. Socket for mounting on a PCB, comprising a base structure and at least 2 rows of at least 40 metal pins, wherein the base structure has been made of a halogen free flame retardant thermoplastic polymer composition comprising a polyamide polymer, a flame retardant system and optionally one or more other components wherein 0
- the polyamide polymer has a melting temperature of at least 255□C,
- the flame retardant system comprises a combination of a melamine condensation product and a phosphinic acid salt of the formula (I) and/or a diphosphinic acid salt of the formula (II), and/or polymers of these 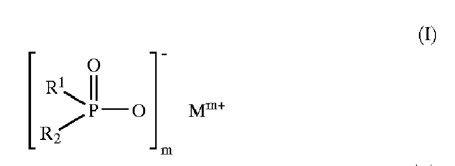 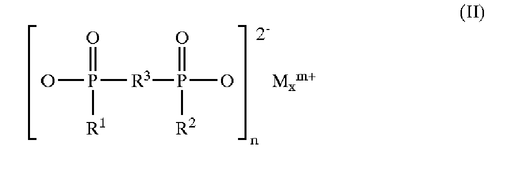 where
R1, R2 are identical or different and are C1-C6- alkyl, linear or branched, and/or aryl;
R3 is C1-C10-alkylene, linear or branched, C6-C10-arylene, alkylarylene or -arylalkylene;
M is an Mg, Ca, Al, Sb, Sn, Ge, Ti, Zn, Fe, Zr, Ce, Bi, Sr, Mn, Li, Na, and/or K;
m is 1 to 4;
n is 1 to 4; and
x is 1 to 4;
- the thermoplastic polymer composition comprises at most 1 wt.% relative to the total weight of the thermoplastic polymer composition of a metal borate, and
- the thermoplastic polymer composition has a melt flow length, measured by a spiral flow test in a spiral cavity with dimensions 280 x 15 x 1 mm at a temperature 20°C above the melt temperature of the polyamide polymer at 100 MPa effective injection pressure, of at least 150 mm.

4. Socket according to claim 3, wherein the thermoplastic polymer composition has a flame retardancy rating, measured according UL standards, of at least V-2 at 1.6 mm.

5. Socket according to claim 3 or 4, wherein the melamine condensation product comprises melam.

6. Socket according to any of claims 3-5, wherein the phosphinate compound is an aluminium alkyl phosphinate, a calcium alkyl phosphinate or a zinc alkyl phosphinate, or any combination thereof.

7. Socket according to any of claims 3-6, wherein the thermoplastic polymer composition comprises a filler and / or a fibrous reinforcing agent.

8. Process for assembling an electronic assembly comprising a socket mounted on a PCB according to claim 1, wherein the socket is mounted on the PCB by a lead free soldering process with a peak temperature of at least 250°C.

9. Thermoplastic polymer composition consisting of
(e) 75-30 wt.% polyamide polymer,
(f) 20-40 wt.% of a combined amount of the phosphinate compound and the melamine condensation product,
(g) 5-40 wt.% of glass fibers,
(h) 0-10 wt.% other components
wherein
- the wt.% of (a-d) is relative to the relative to the total weight of the composition and the sum of (a-d) is 100 %
- the thermoplastic polymer composition comprises at most 0.5 wt.% relative to the total weight of the thermoplastic polymer composition of a metal borate, and
- the thermoplastic polymer composition has a melt flow length, measured by a spiral flow test in a spiral cavity with dimensions 280 x 15 x 1 mm at a temperature 20°C above the melt temperature of the polyamide polymer at 100 MPa effective injection pressure, of at least 150 mm.

10. Thermoplastic polymer composition according to claim 9, wherein the thermoplastic polymer composition has a flame retardancy rating, measured according UL standards, of at least V-2 at 1.6 mm.

11. Thermoplastic polymer composition according to claim 9 or 10, wherein the melamine condensation product comprises melam.

12. Thermoplastic polymer composition according to any of claims 9-11, wherein the phosphinate compound is an aluminium alkyl phosphinate, a calcium alkyl phosphinate or a zinc alkyl phosphinate, or any combination thereof.
